# EUROPÄISCHE PATENTANMELDUNG

(11) **EP 1 389 037 A2**
(43) Veröffentlichungstag der Anmeldung: **11.02.2004**
(21) Anmeldenummer: 03015930.5
(22) Anmeldetag: 12.07.2003
(51) Int. Cl.: H05K 5/00

(54) **Gehäuse zur Aufnahme elektrischer und/oder elktronischer Bauteile**

(30) Priorität: 05.08.2002 EP 02016987
(71) Anmelder: Tyco Electronics AMP GmbH, 64625 Bensheim (DE)
(72) Erfinder: Ryll, Jürgen, 63329 Egelsbach (DE); Nickelfeld, Peter, 63225 Langen (DE); Siotto, Michael, 63739 Aschaffenburg (DE)
(74) Vertreter: Patentanwaltskanzlei WILHELM & BECK

(57) **Zusammenfassung**

Die Erfindung betrifft ein Gehäuse (1) zur Aufnahme elektrischer und/oder elektronischer Bauteile, bestehend aus einem elektrisch nicht leitfähigen Material, insbesondere einem Kunststoff-Material, mit einem Kontaktierbereich (3) zum Festlegen einer elektrischen Anschlussleitung sowie mit mindestens einer aus einem elektrisch leitfähigen Material bestehenden Befestigungsbuchse (2). Ein erfindungsgemäßes Gehäuse (1), das einen zuverlässigen Masseanschluss (4) gewährleistet und gleichzeitig wasserdicht ist, ist gekennzeichnet durch einen an der Umfangsfläche mindestens einer Befestigungsbuchse (2) anschließbaren und in den Kontaktierbereich (3) reichenden Masseanschluss (4).

## Beschreibung

Die Erfindung betrifft ein Gehäuse zur Aufnahme elektrischer und/oder elektronischer Bauteile, bestehend aus einem elektrisch nicht leitfähigen Material, insbesondere einem Kunststoff-Material, mit einem Kontaktierbereich zum Festlegen einer elektrischen Anschlussleitung sowie mit mindestens einer aus einem elektrisch leitfähigen Material bestehenden Befestigungsbuchse.

Derartige Gehäuse sind in den unterschiedlichsten Ausführungsformen bekannt. Um die elektrisch leitfähigen Bauteile von Anlagen und Betriebsmitteln von den normalerweise unter Spannung stehenden Teilen zu isolieren, werden die elektrisch leitende Bauteile, wie beispielsweise Befestigungsbuchsen, aufweisenden Gehäuse über einen Masseanschluss geerdet. Eine solche Erdung ist notwendig, um einerseits bei abgeschirmten Kabeln das Schirmgeflecht zu erden, damit elektrische Felder keine Störungen des abgeschirmten Leiters erzeugen und andererseits bei stromführenden Kabeln in einem Störfall Kurzschlussströme über den Masseanschluss abzuleiten, so dass an den elektrisch leitfähigen Teilen keine einen Benutzer möglicherweise gefährdende Spannung anliegt.

Bei Gehäusen der eingangs genannten Art besteht das Problem, die an den Kontaktierbereich anzuschließende elektrische Anschlussleitung zuverlässig erden zu können. Um bei den aus der Praxis bekannten, meist aus Kunststoff hergestellten Gehäusen die elektrische Anschlussleitung zuverlässig erden zu können, werden als Masseanschluss Ringzungen verwendet, die in der Art einer Unterlegscheibe auf die Stirnfläche der Befestigungsbuchse aufgelegt und mittels der in die Befestigungsbuchse einzusetzenden Schraube an der Befestigungsbuchse festgelegt werden. An die Ringzunge kann ein Erdungskabel des elektrischen Anschlusskabels angeschlossen werden, so dass im Falle einer Störung der Kurzschlussstrom über die Ringzunge und eine in die Befestigungsbuchse eingedrehte Schraube beispielsweise auf eine Fahrzeugkarosserie abgeleitet werden kann.

Da es bei dieser Art des Masseanschlusses zwingend notwendig ist, dass ein direkter Kontakt zwischen der Befestigungsbuchse und der Ringzunge besteht, ist ein solchermaßen ausgestaltetes Gehäuse aufgrund des kaum abdichtbaren Metall-Metall Kontaktes am Masseanschluss nicht, oder nur sehr beschränkt verwendbar, wenn ein wasserdichtes Gehäuse benötigt wird.

Davon ausgehend liegt der Erfindung die Aufgabe zugrunde, ein Gehäuse zur Aufnahme elektrischer und/oder elektronischer Bauteile so auszugestalten, das einerseits einen sichern Masseanschluss ermöglicht, andererseits aber auch wasserdicht ist.

Die Lösung dieser Aufgabenstellung ist erfindungsgemäß gekennenzeichnet durch einen an der Umfangsfläche mindestens einer Befestigungsbuchse anschließbaren und in den Kontaktierbereich reichenden Masseanschluss.

Durch die erfindungsgemäße Verlagerung des Masseanschlusses weg von der Stirnfläche der Befestigungsbuchse hin zur Umfangsfläche der Befestigungsbuchse ist es erstmalig möglich, auf einfache Weise ein mit einem Masseanschluss versehenes Kunststoffgehäuse zu fertigen, das auch problemlos wasserdicht abzudichten ist, da der Masseanschluss im Gehäuseinneren an der Umfangsfläche der Befestigungsbuchse angeschlossen ist und von dort bis in den zum Festlegen der elektrischen Anschlussleitung dienenden Kontaktierbereich reicht.

Gemäß einer ersten Ausführungsform der Erfindung wird vorgeschlagen, dass der Masseanschluss als an der Befestigungsbuchse festlegbarer Kontaktstift ausgebildet ist, der in den Kontaktierbereich ragt. Diese Ausgestaltungsform des Masseanschlusses ist besonders einfach und kostengünstig herstellbar, da es lediglich notwendig ist, den Kontaktstift an der Umfangsfläche der Befestigungsbuchse anzuschließen.

Um den Kontaktstift sicher und dauerhaft an der Umfangsfläche der Befestigungsbuchse festlegen zu können weist der Kontaktstift gemäß einer praktischen Ausführungsform der Erfindung einen Einpressbereich auf, über den der Kontaktstift an der Befestigungsbuchse festlegbar ist. Vorteilhafterweise ist dieser Einpressbereich als an einem freien Ende des Kontaktstiftes ausgebildete Aufweitung des Kontaktstiftes ausgebildet. Die Aufweitung ermöglicht ein Verrasten oder Einpressen des Einpressbereichs des Kontaktstiftes

Zur Aufnahme des Kontaktstiftes des Masseanschlusses wird vorgeschlagen, dass an der Befestigungsbuchse ein Anschlussbereich zur Aufnahme des Einpressbereichs des Kontaktstiftes ausgebildet ist, so dass eine definierte Position zur Kontaktierung des Masseanschlusses vorliegt. Der Anschlussbereich ist gemäß einer praktischen Ausführungsform der Erfindung als aus der Umfangsfläche der Befestigungsbuchse herausgebogene, mit einer Aufnahmeöffnung für den Kontaktstift versehene Lasche ausgebildet. Eine solche Lasche ist beispielsweise durch Freistanzen aus dem Material der Befestigungsbuchse einfach und schnell herstellbar.

Gemäß einer zweiten erfindungsgemäßen Ausführungsform wird vorgeschlagen, dass der Masseanschluss als auf die Befestigungsbuchse aufsetzbarer Kontaktring ausgebildet ist. Die Ausgestaltungsform hat den Vorteil, dass sie auf bestehende Befestigungsbuchsen anwendbar ist, das heißt, dass an der Befestigungsbuchse kein besonderer Anschlussbereich ausgebildet werden muß, um den Masseanschluss an der Umfangsfläche der Befestigungsbuchse anschließen zu können.

Der vorzugsweise mit einem tangential abstehenden Kontaktstift versehene Kontaktring weist gemäß einer praktischen Ausführungsform der Erfindung angeformte Klemmbereiche zum Festlegen des Kontaktrings auf der Befestigungsbuchse auf. Zum Anschließen des Erdungskabels ragt der tangentiale Kontaktstift in den Kontaktierbereich hinein.

Weiterhin wird mit der Erfindung vorgeschlagen, dass bei einem Gehäuse, das mehrere Befestigungsbuchsen aufweist, jede von den anderen Befestigungsbuchsen elektrisch isoliert im Gehäuse angeordnete Befestigungsbuchse einen eigenen an der Umfangsfläche dieser Befestigungsbuchse anschließbaren Masseanschluss aufweist, um sicherzustellen, dass im Störfall jede Befestigungsbuchse spannungsfrei ist.

Gemäß einer alternativen Ausführungsform der Erfindung sind bei einem Gehäuse, das mehrere Befestigungsbuchsen aufweist, alle Befestigungsbuchsen elektrisch leitend miteinander verbunden sind, so dass es ausreichend ist, an der Umfangsfläche nur einer Befestigungsbuchse den Masseanschluss anzuschließen.

Um ein wasserdichtes Gehäuse herzustellen, wird erfindungsgemäß vorgeschlagen, dass die Befestigungsbuchse nach dem Festlegen des Masseanschlusses mit einem elektrisch nicht leitenden Material, insbesondere einem Kunststoff-Material, umspritzbar ist. Auf diese Weise wird einerseits der Masseanschluss ortsfest und lagegenau an der Befestigungsbuchse fixiert und andererseits sichergestellt, dass das Gehäuse auch im Bereich des Masseanschlusses wasserdicht ist, da aufgrund des Umspritzens, oder alternativ Umgießens, auf zusätzliche Dichtungsmittel verzichtet werden kann.

Ferner wird erfindungsgemäß vorgeschlagen, dass der Bereich, an dem ein Erdungskabel an den Masseanschluss anschließbar ist, als vom Gehäuseinneren separiert angeordnete Steckverbindung ausgebildet ist. Der Anschluss des Erdungskabels an den Masseanschluss ist auf diese Weise mittels entsprechender Maßnahmen einfach als wasserdichte Stecker-Kupplung-Verbindung auszubilden.

Vorteilhafterweise wird ein erfindungsgemäß ausgebildetes Gehäuse so eingesetzt, dass der Masseanschluss zur Erdung des Schirmgeflechts eines abgeschirmten Kabels dient. In diesem fall wird durch die direkte Verbindung eine niederohmige Erdung erzielt, die Voraussetzung für den wirkungsvollen Einsatz einer abgeschirmten Leitung ist.

Schließlich wird erfindungsgemäß vorgeschlagen, dass die am Kontaktierbereich anschließbare elektrische Anschlussleitung ein mit mindestens einem Erdungskabel versehener fertig kontektionierter Kabelbaum ist.

Weitere Merkmale und Vorteile der Erfindung ergeben sich aus der nachfolgenden Beschreibung der zugehörigen Zeichnung, in der vier Ausführungsbeispiele eines erfindungsgemäßen Gehäuses für eine elektrische Steckverbindung nur beispielhaft schematisch dargestellt sind. In der Zeichnung zeigt:
- Figur 1: eine perspektivische Ansicht eines erfindungsgemäßen Gehäuses;
- Figur 2: einen Schnitt entlang der Schnittlinie II-II gemäß Figur 1;
- Figur 3: eine perspektivische Ansicht eines an einer Befestigungsbuchse angeschlossenen Masseanschlusses gemäß einer ersten erfindungsgemäßen Ausführungsform;
- Figur 4: eine perspektivische Ansicht eines an einer Befestigungsbuchse angeschlossenen Masseanschlusses gemäß einer zweiten erfindungsgemäßen Ausführungsform;
- Figur 5: eine perspektivische Ansicht eines an einer Befestigungsbuchse angeschlossenen Masseanschlusses gemäß einer dritten erfindungsgemäßen Ausführungsform;
- Figur 6: eine perspektivische Ansicht eines an einer Befestigungsbuchse angeschlossenen Masseanschlusses gemäß einer vierten erfindungsgemäßen Ausführungsform;
- Figur 7: eine Vorderansicht des Kontaktringes gemäß Figur 6, eine erste Fertigungsstufe des Kontaktringes darstellend und
- Figur 8: eine perspektivische Ansicht des Kontaktringes ge mäß Figur 6 und 7 im auf einer Befestigungsbuchse festlegbaren Zustand.

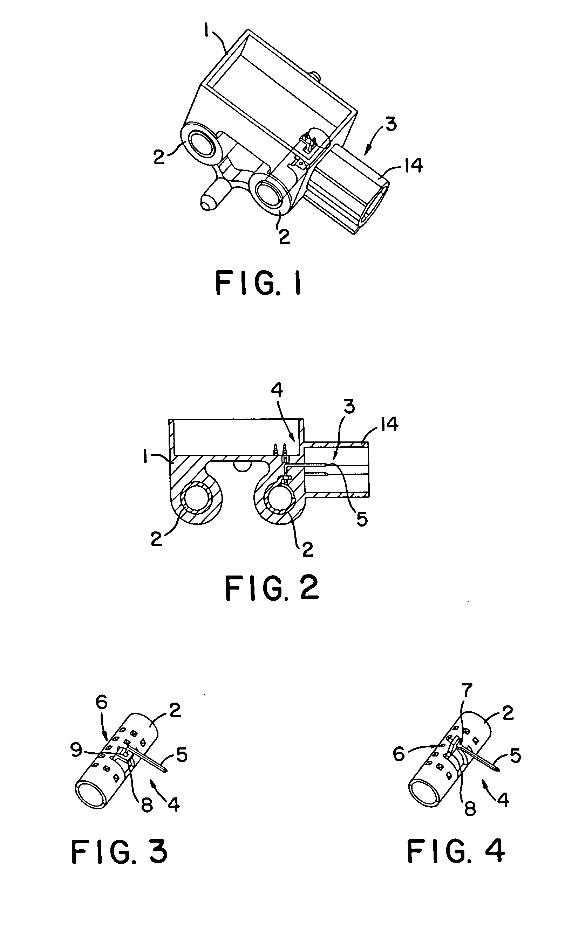

Die Abbildung Figur 1 zeigt eine perspektivische Ansicht eines Gehäuse 1 zur Aufnahme elektrischer und/oder elektronischer Bauteile. Zur besseren Verdeutlichung des Aufbaus des Gehäuses 1 ist das Gehäuse 1 im leeren Zustand, das heißt, ohne im Gehäuse 1 angeordnete elektrischer und/oder elektronischer Bauteile dargestellt.

Zum Festlegen des aus einem nicht elektrisch leitfähigen Material, insbesondere einem Kunststoff-Material, bestehenden Gehäuses 1 an einem anderen Bauteil, insbesondere einer Fahrzeugkarosserie, weist das Gehäuse 1 zwei in das Gehäuse 1 integrierte Befestigungsbuchsen 2 auf, von denen in der Abbildung Fig. 1 nur eine (die rechte) zeichnerisch vollständig dargestellt ist. In die Befestigungsbuchsen 2 sind Befestigungsmittel, beispielsweise Schrauben, zum festlegen des Gehäuses 1 einfügbar. Die Befestigungsbuchsen 2 bestehen aus einem elektrisch leitfähigen Material, insbesondere Metall.

Alternativ zu der dargestellten Ausführungsform mit zwei Befestigungsbuchsen 2 im Gehäuse 1 ist es selbstverständlich auch möglich, dass in das Gehäuse 1 nur eine oder aber mehrere Befestigungsbuchsen 2 integriert sind.

Zum Anschließen einer nicht dargestellten elektrischen Anschlussleitung weist das Gehäuse 1 weiterhin einen Kontaktierbereich 3 auf, an die Anschlussleitung, beispielsweise ein fertig konfektionierter Kabelbaum, anschließbar ist.

Zum Erden der mindestens ein Erdungskabel aufweisenden, an den Kontaktierbereich 3 anschließbaren elektrischen Anschlussleitung, ist die Befestigungsbuchse 2 mit einem Masseanschluss 4 versehenen, um im Störfall auftretende Kurzschlussströme über die Befestigungsbuchse 2 und eine in die Befestigungsbuchse 2 eingedrehte Schraube auf die Fahrzeugkarosserie ableiten zu können oder beim Anschluss abgeschirmter Leitungen das Schirmgeflecht zu erden.

Den Abbildungen Figur 3 bis 6 sind vier Ausführungsbeispiele zu entnehmen, wie der Masseanschluss 4 an der Befestigungsbuchse 2 anschließbar ist. Wie aus den Abbildungen ersichtlich, ist allen Ausführungsbeispielen gemein, dass der Masseanschluss 4 die Umfangsfläche der Befestigungsbuchse 2 kontaktiert und bis in den Kontaktierbereich 3 hineinragt. Die Kontaktierung an der Umfangsfläche der Befestigungsbuchse 2 ermöglicht eine Verlagerung des Masseanschlusses 4 fort von der Stirnseite der Befestigungsbuchse 2, wie dies aus dem Stand der Technik bekannt ist, in das innere des Gehäuses 1.

Der Schnittdarstellung gemäß Figur 2 ist zu entnehmen, dass ein solchermaßen ausgebildeter und angeordneter Masseanschluss 4 so weit in das Innere des Gehäuses 1 verlagerbar ist, dass die Befestigungsbuchse 2 mit dem daran kontaktierten Masseanschluss 4 beispielsweise durch Umspritzen oder Umgießen in das das Gehäuse 1 bildende Material eingebettet werden kann. Dieses Einarbeiten des Masseanschlusses 4 in das Gehäuse 1 ermöglicht auf einfache und zuverlässige Art und Weise die Herstellung eines wasserdichten Gehäuses 1.

Die in den Abbildungen Figur 3 bis 6 dargestellten Ausführungsbeispiele unterscheiden sich dadurch voneinander, wie der Masseanschluss 4 an der Umfangsfläche der Befestigungsbuchse 2 angeschlossen ist.

Bei den drei Ausführungsbeispielen gemäß den Abbildungen Figur 3, 4 und 5 erfolgt die Kontaktierung der Umfangsfläche der Befestigungsbuchse 2 über einen Kontaktstift 5, der an einem speziell ausgebildeten Anschlussbereich 6 der Befestigungsbuchse 2 festlegbar ist. Die Kontaktstifte 5 dieser drei dargestellten Ausführungsbeispiele weisen an dem der Kontaktierung mit der Befestigungsbuchse 2 dienenden freien Ende einen als Aufweitung des Stiftdurchmessers ausgebildeten Einpressbereich 7 auf.

Der zur Aufnahme des Kontaktstiftes 5 dienende Anschlussbereich 6 der Befestigungsbuchse 2 ist bei diesen Ausführungsformen als aus der Umfangsfläche der Befestigungsbuchse 2 freigestanzte und herausgebogene Lasche 8 ausgebildet, in der eine Aufnahmeöffnung 9 zum Einsetzen des Einpressbereichs 7 des Kontaktstiftes 5 ausgebildet ist.

Wie aus den Abbildungen Figur 3 bis 5 weiterhin ersichtlich ist, zeigt freie Ende des Kontaktstiftes 5, an das das Erdungskabel anschließbar ist tangential fort von der Befestigungsbuchse 2, um, wie aus Fig. 2 ersichtlich, bis in den Kontaktierbereich 3 zu ragen. Diese Ausrichtung wird bei der in Figur 3 dargestellten ersten Ausführungsform dadurch erreicht, dass die Lasche 8 zur Ausbildung des Anschlussbereichs 6 zweifach rechtwinklig so abgewinkelt ist dass der die Aufnahmeöffnung 9 aufweisende Bereich tangential zur Befestigungsbuchse 2 verläuft. Das den Einpressbereich 7 aufweisende freie Ende des Kontakstiftes 5 ist zur Einsetzen in die Aufnahmeöffnng 9 rechtwinklig nach unten abgebogen, so dass das zum Anschließen des Erdungskabels dienende freie Ende des Kontaktstiftes 5 parallel zum Endbereich der Lasche 8 und somit tangential zur Befestigungsbuchse 2 ausgerichtet ist.

Diese in Fig. 3 dargestellte erste Ausführungsform ist auch der Schnittdarstellung gemäß Figur 2 zu entnehmen.

Bei der in Figur 4 dargestellten zweiten Ausführungsform weist die Lasche 8 einmalig rechtwinklig abgewinkelt radial von der Umfangsfläche der Befestigungsbuchse 2 fort. Der Kontaktstift 5 ist in diesem Fall als gerader Stift ausgebildet, der Senkrecht zu der Lasche 8 und somit tangential zur Befestigungsbuchse 2 ausgerichtet ist.

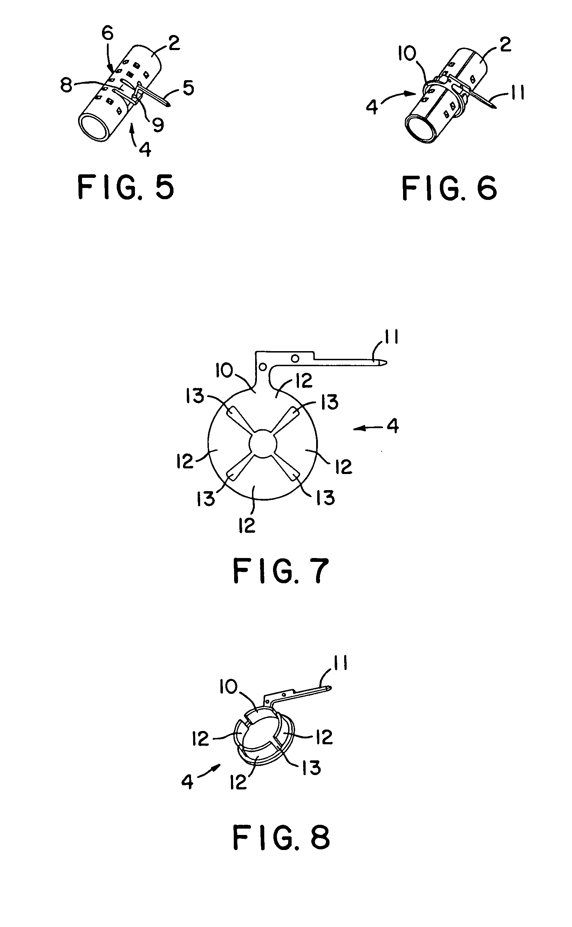

Die Lasche 8 des Anschlussbereichs 6 gemäß der in Figur 5 dargestellten dritten Ausführungsform ist so aus der Umfangsfläche der Befestigungsbuchse 2 herausgebogen, dass sie tangential von der Befestigungsbuchse 2 fortweist. Das den Einpressbereich 7 aufweisende freie Ende des Kontaktstiftes 5 ist zur Einsetzen in die Aufnahmeöffnung 9 rechtwinklig nach unten abgebogen, so dass das zum Anschließen des Erdungskabels dienende freie Ende des Kontaktstiftes 5 parallel zum Endbereich der Lasche 8 und somit tangential zur Befestigungsbuchse 2 ausgerichtet ist.

Im Gegensatz zu den in den Abbildungen Figur 3 bis 5 dargestellten Ausführungsbeispielen ist der Masseanschluss 4 beider in Figur 6 dargestellten vierten Ausführungsform als auf die Befestigungsbuchse 2 aufsetzbarer Kontaktring 10 ausgebildet.

Wie insbesondere aus den Abbildungen Figur 7 und 8 ersichtlich, weist der Kontaktring 10 zum Anschließen des Erdungskabels einen im wesentlichen tangential zum Kontaktring 10 verlaufenden und in den Kontaktierbereich 3 ragenden Kontaktstift 11 auf. Am Kontaktring 10 ausgebildete Klemmbereiche 12 ermöglichen dem Kontaktring 10 einen sicheren und verdrehsicheren Halt auf der Umfangsfläche der Befestigungsbuchse 2.

Diese Ausgestaltungsform ist vorteilhaft, da es keiner speziellen Ausgestaltung der Befestigungsbuchse 2 bedarf, da der Kontaktring 10 einfach auf die fertige Befestigungsbuchse 2 aufgeschoben wird.

Der Kontaktring 10 besteht bei der dargestellten Ausführungsform, wie aus Figur 7 ersichtlich, aus einem ebenen Blechstanzteil aus dem durch radial verlaufende Schnitte 13 die Klemmbereiche 12 freigestanzt und nachfolgend zur Ausbildung einer Hülse tangential zum äußeren Ring des Kontaktrings 10 nach außen umgebogen werden.

Während die Befestigungsbuchse 2 bei den dargestellten Ausführungsbeispielen als aus einem ebenen Blech gerollte Hülse ausgebildet ist, ist es selbstverständlich auch möglich, die Befestigungsbuchse 2 als durch Drehen oder Ausbohren gefertigte Hülse herzustellen.

Um bei der Ausbildung des Gehäuses 1 als wasserdichtes Gehäuse 1 auch den Kontaktierbereich 3 zum Anschließen der mit dem Erdungskabel versehenen elektrischen Anschlussleitung an den Masseanschluss 4 wasserdicht auszugestalten, enden die in den Kontaktierbereich 3 ragenden freien Enden der Kontaktstifte 5 bzw. 11 in einer vom Inneren des Gehäuses 1 separierten Steckverbindung 14, wie diese den Abbildungen Figur 1 und 2 zu entnehmen ist. Durch das Aufsetzen eines entsprechenden Kupplungsstücks läßt sich so auf einfache Art und Weise eine wasserdichte und sichere Stecker-Kupplung-Verbindung herstellen.

Durch die Anordnung des Masseanschlusses 4 an der Umfangsfläche der Befestigungsbuchse 2 ist es möglich, den Masseanschluss 4 in das Innere des Gehäuses 1 zu verlagern, so dass dieser ortsfest und wasserdicht in das Gehäusematerial einarbeitbar ist.

Neben dem Erden des Erdungskabels der an den Kontaktierbereich 3 anschließbaren elektrischen Anschlussleitung ist es selbstverständlich auch möglich, die in dem Gehäuse 1 anzuordnenden elektrischen und/oder elektronischen Bauteile über den Masseanschluss 4 und/oder die Befestigungsbuchse 2 zu erden.

### Bezugszeichenliste

- 1: Gehäuse
- 2: Befestigungsbuchse
- 3: Kontaktierbereich
- 4: Masseanschluss
- 5: Kontaktstift
- 6: Anschlussbereich
- 7: Einpressbereich
- 8: Lasche
- 9: Aufnahmeöffnung
- 10: Kontaktring
- 11: Kontaktstift
- 12: Klemmbereich
- 13: Schnitt
- 14: Steckverbindung

## Patentansprüche

1. Gehäuse zur Aufnahme elektrischer und/oder elektronischer Bauteile, bestehend aus einem elektrisch nicht leitfähigen Material, insbesondere einem Kunststoff-Material, mit einem Kontaktierbereich (3) zum Festlegen einer elektrischen Anschlussleitung sowie mit mindestens einer aus einem elektrisch leitfähigen Material bestehenden Befestigungsbuchse (2),
**gekennzeichnet durch**
einen an der Umfangsfläche mindestens einer Befestigungsbuchse (2) anschließbaren und in den Kontaktierbereich (3) reichenden Masseanschluss (4).

2. Gehäuse nach Anspruch 1, **dadurch gekennzeichnet, dass** der Masseanschluss (4) im Gehäuseinneren an der Umfangsfläche der Befestigungsbuchse (2) angeschlossen ist.

3. Gehäuse nach Anspruch 1 oder 2, **dadurch gekennzeichnet, dass** der Masseanschluss (4) als an der Befestigungsbuchse (2) festlegbarer Kontaktstift (5) ausgebildet ist, der in den Kontaktierbereich (3) ragt.

4. Gehäuse nach Anspruch 3, **dadurch gekennzeichnet, dass** am Kontaktstift (5) ein Einpressbereich (7) ausgebildet ist, über den der Kontaktstift (5) an der Befestigungsbuchse (2) festlegbar ist.

5. Gehäuse nach Anspruch 4, **dadurch gekennzeichnet, dass** der Einpressbereich (7) als an einem freien Ende des Kontaktstiftes (5) ausgebildete Aufweitung des Kontaktstiftes (5) ausgebildet ist.

6. Gehäuse nach Anspruch 4 oder 5, **dadurch gekennzeichnet, dass** an der Befestigungsbuchse (2) ein Anschlussbereich (6) zur Aufnahme des Einpressbereiches (7) des Kontaktstiftes (5) ausgebildet ist.

7. Gehäuse nach Anspruch 6, **dadurch gekennzeichnet, dass** der Anschlussbereich (6) als aus der Umfangsfläche der Befestigungsbuchse (2) herausgebogene, mit einer Aufnahmeöffnung (9) für den Kontaktstift (5) versehene Lasche (8) ausgebildet ist.

8. Gehäuse nach Anspruch 1 oder 2, **dadurch gekennzeichnet, dass** der Masseanschluss (4) als auf die Befestigungsbuchse (2) aufsetzbarer Kontaktring (10) ausgebildet ist.

9. Gehäuse nach Anspruch 8, **dadurch gekennzeichnet, dass** am Kontaktring (10) ein im wesentlichen tangential abstehender Kontaktstift (11) angeformt ist, der in den Kontaktierbereich (3) ragt.

10. Gehäuse nach Anspruch 8 oder 9, **dadurch gekennzeichnet, dass** am Kontaktring (10) Klemmbereiche (12) zum Festlegen auf der Befestigungsbuchse (2) ausgebildet sind.

11. Gehäuse nach mindestens einem der Ansprüche 1 bis 10, wobei das Gehäuse (1) mehrere Befestigungsbuchsen (2) aufweist, **dadurch gekennzeichnet, dass** jede elektrisch isoliert von den anderen Befestigungsbuchsen (2) angeordnete Befestigungsbuchse (2) einen eigenen an der Umfangsfläche dieser Befestigungsbuchse (2) anschließbaren Masseanschluss (4) aufweist.

12. Gehäuse nach mindestens einem der Ansprüche 1 bis 10, wobei das Gehäuse (1) mehrere Befestigungsbuchsen (2) aufweist, **dadurch gekennzeichnet, dass** alle Befestigungsbuchsen (2) elektrisch leitend miteinander verbunden sind, wobei an der Umfangsfläche einer Befestigungsbuchse (2) ein Masseanschluss (4)anschließbar ist.

13. Gehäuse nach mindestens einem der Ansprüche 1 bis 12, **dadurch gekennzeichnet, dass** die Befestigungsbuchse (2) nach dem Festlegen des Masseanschlusses (4) mit einem elektrisch nicht leitenden Material, insbesondere einem Kunststoff-Material, umspritzbar ist.

14. Gehäuse nach mindestens einem der Ansprüche 1 bis 13, **dadurch gekennzeichnet, dass** der Kontaktierbereich (3), an dem die elektrische Anschlussleitung anschließbar ist, als vom Gehäuseinneren separiert angeordnete Steckverbindung (14) ausgebildet ist.

15. Gehäuse nach mindestens einem der Ansprüche 1 bis 14, **dadurch gekennzeichnet, dass** der Masseanschluss (4) zur Erdung des Schirmgeflechts eines abgeschirmten Kabels dient.

16. Gehäuse nach mindestens einem der Ansprüche 1 bis 15, **dadurch gekennzeichnet, dass** die am Kontaktierbereich (3) anschließbare elektrische Anschlussleitung ein mit mindestens einem Erdungskabel versehener fertig kontektionierter Kabelbaum ist.
